# EUROPEAN PATENT SPECIFICATION

(11) **EP 4 131 357 B1**
(45) Date of publication and mention of the grant of the patent: **06.05.2026**
(21) Application number: 21774917.5
(22) Date of filing: 11.03.2021
(51) Int. Cl.: H01L 23/12, H05K 7/20, H02M 7/48

(54) **POWER CONVERSION DEVICE**
STROMUMWANDLUNGSVORRICHTUNG
DISPOSITIF DE CONVERSION D'ÉNERGIE

(30) Priority: 27.03.2020 JP 2020057944
(43) Date of publication of application: 08.02.2023
(73) Proprietor: Hitachi, Ltd., Tokyo 100-8280 (JP)
(72) Inventor: SEO, Masahiro, Tokyo 100-8280 (JP); TOKUYAMA, Takeshi, Tokyo 100-8280 (JP); ARAKI, Takahiro, Tokyo 100-8280 (JP)
(74) Representative: MERH-IP Matias Erny Reichl Hoffmann Patentanwälte PartG mbB
(86) International application number: PCT/JP2021/009756
(87) International publication number: WO 2021/193090

(56) References cited:
- JP-A- 2001 045 601
- JP-A- 2002 095 267
- JP-A- 2005 064 131
- JP-A- 2019 161 797
- JP-A- H07 231 071
- US-A1- 2009 154 101
- US-B2- 7 834 448

## Description

### Technical Field

The invention relates to a power conversion device.

### Background Art

In the industrial machines and vehicles (for example, automobiles and railroad vehicles), the electrification and the electronic control of power sources are rapidly progressing from the viewpoint of energy saving and precise operation control. Along with this, conventionally, with respect to a power module for controlling the power of a power source and an electronic circuit device for converting electric power using the power module, for example, in the case of an electric vehicle equipped with a power conversion device and a motor, the power conversion device is desired to be thin in order to expand a space inside the vehicle.

The following Patent Literature 1 is known as a background technique for the invention. The Patent Literature 1 discloses a technique for downsizing a power conversion device by making a power module and a capacitor module of the power conversion device sandwich a flow path of cooling water.

### Citation List

### Patent Literature

Patent Literature 1: Japanese Patent Laid-Open No. 2009-44891
Patent Literature 2: JP 2019 161797 A
Patent Literature 3: JP 2001 045601 A
Patent Literature 4: US 2009/154101 A1
Patent literature 2 describes a power conversion device comprising a refrigerant path with power modules arranged inside the refrigerant path.
Patent literature 3 describes a heat sink attached to a power conversion device.
Patent literature 4 describes a power conversion with a cooling system arranged therein.

### Summary of Invention

### Technical Problem

When a thinner power conversion device than this is further required, the technique described in the Patent Literature 1 hardly changes the configuration in reply to this requirement. In view of this, the invention is to realize a thinner power conversion device, by having a cooling performance that can efficiently cool a power conversion element, a power smoothing element, wiring, and the like on a circuit substrate and at the same time by having a sealing performance that can prevent a refrigerant flowing inside a flow path from leaking to the outside.

### Solution to Problem

A power conversion device according to the invention incudes a capacitor for smoothing a direct current power, a plurality of power modules for converting the direct current power into an alternating current power, a first substrate on which the power modules are arranged, a second substrate arranged opposite to the first substrate, a first flow path forming body that forms a flow path for passing a refrigerant with the both surfaces of the first substrate and the second substrate joined together, and a second flow path forming body that forms the flow path together with the surface of the first substrate, in which the both surfaces of the power modules are cooled by the refrigerant.

### Advantageous Effects of Invention

According to the invention, it is possible to realize a thinner power conversion device that has both the cooling performance and the sealing performance.

### Brief Description of Drawings

Fig. 1 is an electric circuit diagram of a power conversion device according to the invention.
Fig. 2 is an explanatory view of the power conversion device according to a first embodiment of the invention.
Fig. 3 is a view when a top of the flow path forming body 27 in Fig. 2 and a control circuit substrate are installed there.
Fig. 4 is a view of a first circuit substrate with the flow path forming body 27 removed from Fig. 2.
Fig. 5 is an explanatory view of a flow path forming body 3 with the first circuit substrate 1 removed from Fig. 4.
Fig. 6 is a cross-sectional view taken along the line A-A' of Fig. 5.
Fig. 7 is a view of a second circuit substrate 2.
Fig. 8 is an explanatory view of the flow path forming body 3 (rear surface of Fig. 5) with the second circuit substrate 2 removed from Fig. 7.
Fig. 9 is a cross-sectional view taken along the line B-B' of Fig. 8.
Fig. 10 is an explanatory view of a power conversion device according to a second embodiment of the invention.
Fig. 11 is an explanatory view of a flow path forming body 27A formed around a power module 4A of Fig. 10.
Fig. 12 is an explanatory view of a flow path forming body 3A with a first circuit substrate 1A removed from Fig. 10.
Fig. 13 is a view of a rear surface of the flow path forming body 3A of Fig. 12.
Fig. 14 is an explanatory view of a power conversion device according to a third embodiment of the invention.
Fig. 15 is an explanatory view of a power conversion device according to a fourth embodiment of the invention.

### Description of Embodiments

Hereinafter, embodiments of the invention will be described using the drawings.

### (Configuration of Electric Circuit of Power Conversion Device)

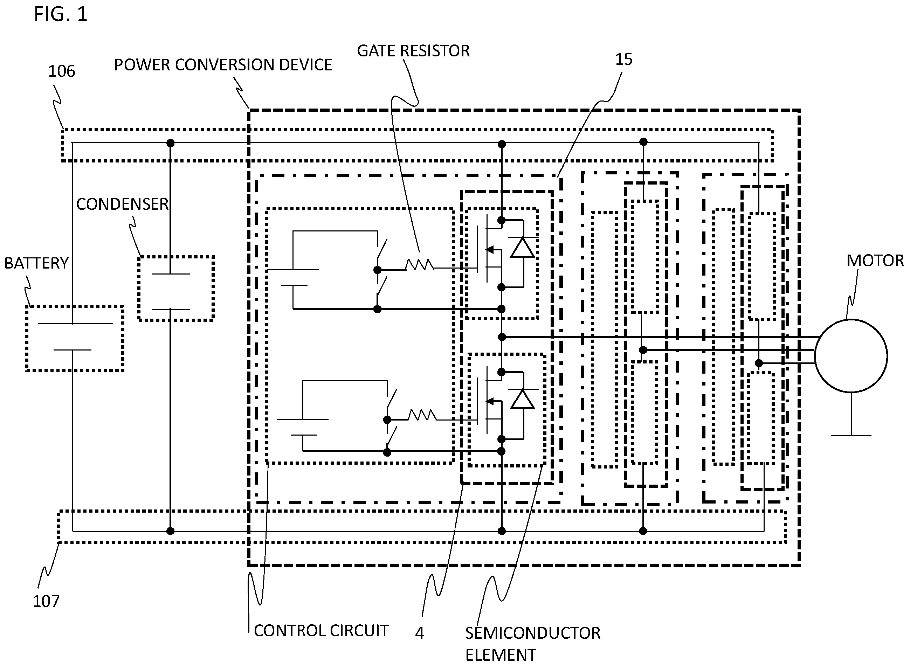

Fig. 1 is an electric circuit diagram of a power conversion device of the invention.

The power conversion device converts a direct current power supplied from a battery mounted in a vehicle, into an alternating current power, smooths the power with capacitors connected in parallel, and outputs the same to a motor. The power conversion device includes a one leg power module 4 with two semiconductor elements connected in series for three phases.

In each of one leg power modules 4, the current flowing to the semiconductor elements in the upper and lower arms is controlled by switching ON and OFF according to a control signal input through a signal wiring connected via a gate resistor. Each of the three-phase one leg power modules 4, with the input wiring at a high voltage side 106 and the input wiring at a low voltage side 107 connected in parallel, is connected to a stator winding of a motor at the midpoint of the semiconductor elements connected in series.

Further, one leg inverters 15 for three phases, each combining the one leg power module 4 and the control circuit, are connected in parallel at the high voltage side of the input wiring 106 and the low voltage side of the input wiring 107 and output the three-phase alternating currents to the motor according to the ON and OFF control.

The one leg power module 4 is formed by, for example, a combination of IGBT (Insulated Gate Bipolar Transistor) and a diode or MOSFET (Metal Oxide Semiconductor Field Effect Transistor).

### (First Embodiment)

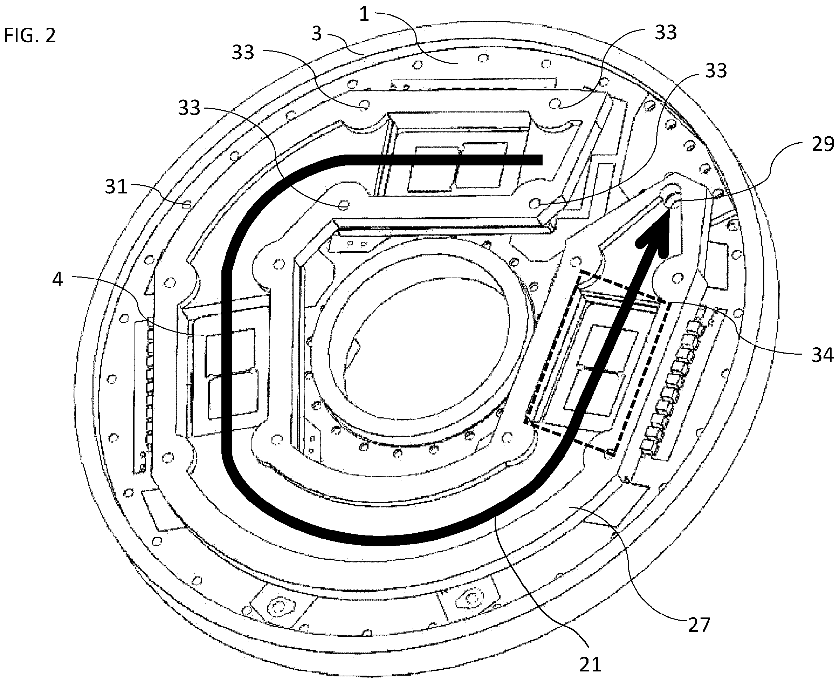

Fig. 2 is an explanatory view of a power conversion device according to a first embodiment of the invention.

Fig. 2 is a view showing a first circuit substrate 1 on which the power modules 4 of the power conversion device are arranged in a circumferential direction for three phases, and on the surface of the above substrate, a flow path forming body 27 is installed to form a flow path for passing the refrigerant to cool the respective power modules 4.

The first circuit substrate 1 is fitted in a flow path forming body 3 larger in a radial direction than the circuit substrate, along the fringe of the circumference. A plurality of screw holes 31 are provided on the circumference to fix together the first circuit substrate 1 and the flow path forming body 3.

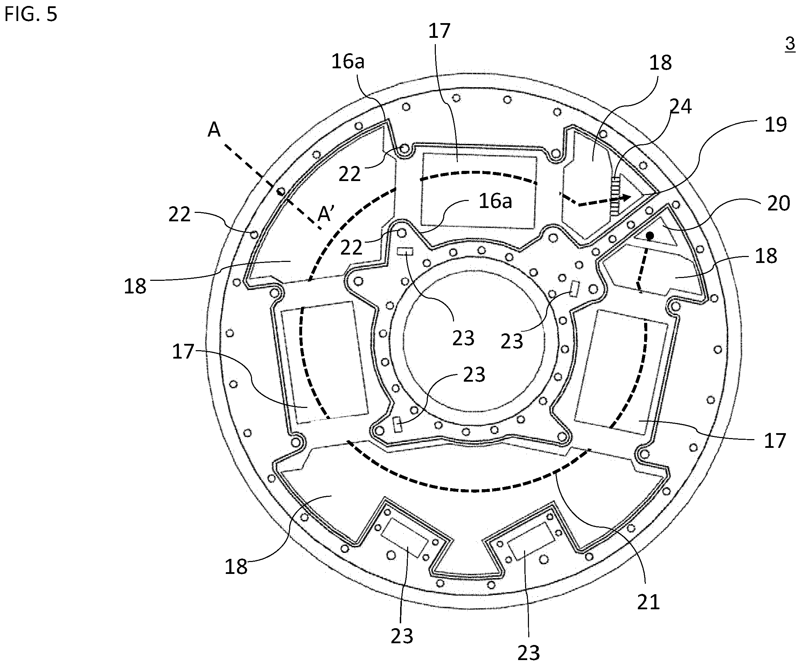

A flow path forming body 27 forms a flow path with the surface of the first circuit substrate joined thereto and has through holes 34 respectively at the positions corresponding to the locations of the respective power modules 4, so that a refrigerant as the fluid flowing inside the flow path forming body 27 can cool the power modules 4. In other words, the flow path forming body 27 includes the through holes 34 working as module flow path units for individually cooling a plurality of the power modules 4. The refrigerant passing through the flow path forming body 27 flows like an arrow 21 indicating the flow of the refrigerant, passes through a flow path hole 25 of the first circuit substrate described later from a flow path outlet unit 29, and flows into a flow path opening unit 20 (refer to Fig. 5) of the flow path forming body 3.

Further, the flow path forming body 27 is fixed to the surface of the circuit substrate 1 through a plurality of screw holes 33. The plural screw holes 33 are provided at the four corners of each through hole 34, to fasten the flow path forming body 27, the first circuit substrate 1, and the flow path forming body 3 at the same time, as fastening holes.

Here, the flow path forming body 27 adheres to the first circuit substrate 1 only at the portions around the resin covering the power modules 4 to prevent the corrosion of the electric parts. The flow path forming body 27 is formed not to be in contact with the elements for signal control on a signal wiring unit 8 described later, connection terminals 9c and 9d, and crimp terminals 10a and 10b.

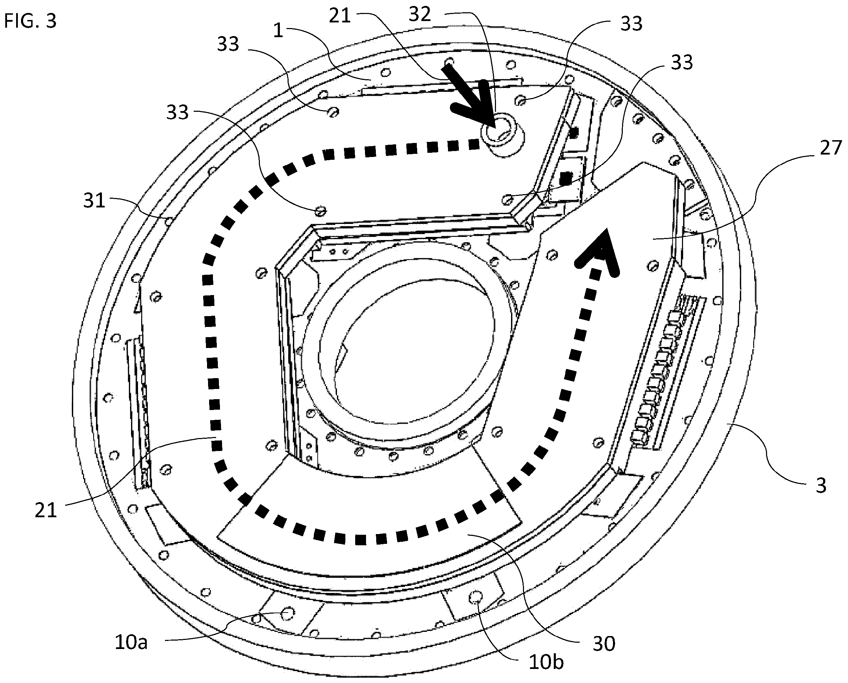

Fig. 3 is a view when the top of the flow path forming body 27 in Fig. 2 and the control circuit substrate 30 are installed there. Here, the control circuit substrate 30 includes the control circuits of Fig. 1 for three phases, to output the control signals of the respective power modules 4.

The top of the flow path forming body 27 prevents the leakage of the fluid inwardly flowing, to the outside. Further, a flow path inlet unit 32 for taking in the refrigerant flowing to the whole power conversion device is provided on the top of the flow path forming body 27. Further, the plural screw holes 33 are provided also on the top of the flow path forming body 27 at the same positions as mentioned above, as the fastening holes that can fasten the flow path forming body 27, the first circuit substrate 1, and the flow path forming body 3 at the same time.

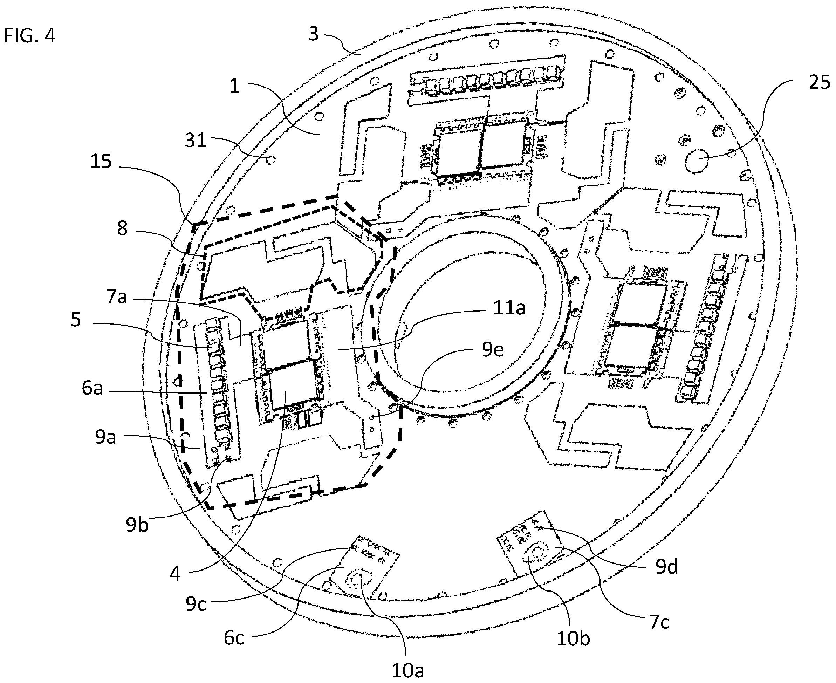

At first, an electrical connection about the control circuit substrate 30 will be described. The control circuit substrate 30 is connected to the signal wiring unit 8 (refer to Fig. 4) arranged on the first circuit substrate 1, with a cable and a connector, and has an integrated circuit for issuing a signal controlling the magnitude of the output voltage of a signal and creating an output alternating current waveform (not illustrated). The integrated circuit includes terminals and wiring for connecting with a total control unit of the power conversion device on the control circuit substrate 30. According to this, the circuit substrate is controlled simultaneously with the integrated circuit of the other power conversion device, to drive the motor in cooperation with each other.

Next, the arrangement of the control circuit substrate 30 will be described. The control circuit substrate 30 is arranged at the surface opposite to the surface in contact with the first circuit substrate 1 of the flow path forming body 27, in order to avoid the integrated circuit of the control circuit substrate 30 from heating to a high temperature, and fixed there with a screw and the like. In other words, in the flow path forming body 27 having a pair of facing surfaces, the above body is in contact with the first circuit substrate 1 on one surface and the control circuit substrate 30 is provided on the other surface thereof. According to this, the control circuit substrate 30 is indirectly cooled through the flow path forming body 27. Here, a through hole may be formed on the top of the flow path forming body 27 and the control circuit substrate 30 may be fitted there, to be directly cooled by the flow.

Further, the control circuit substrate 30 is provided at a distance from the direct current power flowing crimp terminals 10a and 10b and power modules 4 as far as possible, not to cause a malfunction of the integrated circuit of the control circuit substrate 30 due to the influence of high frequency voltage at a switching time, electrostatic noise by current, and radiation noise.

Fig. 4 is a view of the power conversion device with the flow path forming body 27 removed from Fig. 2 or Fig. 3.

The first circuit substrate 1 is multilayered, and the wirings at the high voltage side and the low voltage side of the voltage input to the power module 4 are isolated with an insulator. As mentioned above, the power modules 4 for three phases are provided on the first circuit substrate 1 of the power conversion device. Further, a one leg inverter 15 includes the power module 4, a capacitor 5, a signal wiring unit 8, and an output wiring unit 11a. The capacitor 5 is a capacitor for smoothing the direct current power supplied from the battery, and the plural power modules 4 convert the direct current power into the alternating current power.

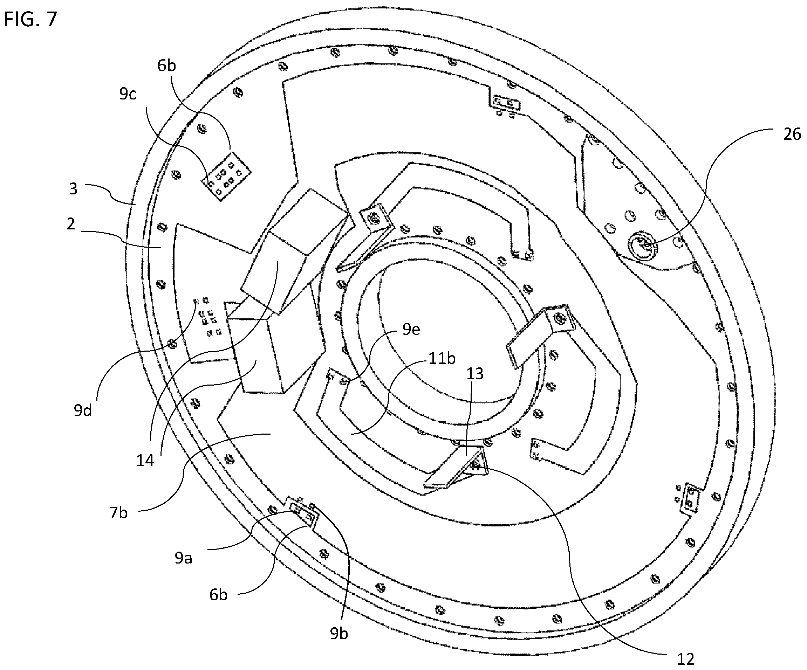

The respective three-phase one leg inverters 15 are electrically connected to the second circuit substrate 2 described later in Fig. 7 arranged opposite to the first substrate, as the circuits for passing a main current for three-phase alternating current conversion. Further, the first circuit substrate 1 includes the flow path hole 25, through which the refrigerant flowing from the flow path outlet unit 29 of the above-mentioned flow path forming body 27 flows to the flow path formed by the flow path forming body 3 described later.

The electrical connection of the first circuit substrate 1 (and the electrical connection of the second circuit substrate 2 described later) will be described. As for the power module 4, the semiconductor element is upwardly and downwardly jointed by soldering in a way of sandwiching a copper foil of the semiconductor element, hence to extend the output terminal to the copper foil portion. Further, the power module 4 includes a power conversion element (a combination of IGBT and diode or MOSFET) which conducts or shuts off the electricity between the low voltage side and the output side and a semiconductor element which conducts or shuts off between the high voltage side and the output side. The high voltage direct current wiring unit 6a is connected to the high voltage direct current wiring unit 6b of the second circuit substrate 2 of Fig. 7 described later through the connection terminal 9a. The low voltage direct current wiring unit 7a is connected to the low voltage direct current wiring unit 7b of the second circuit substrate 2 through the connection terminal 9b. The output wiring unit 11a connected to the power module 4 is connected to the output wiring unit 11a of the second circuit substrate through the connection terminal 9e.

A high voltage direct current wiring unit 6c indicated in the bottom of Fig. 4 is connected there through a connection terminal 9c from the high voltage direct current wiring unit 6b of the second circuit substrate 2. Further, the high voltage direct current wiring unit 6c is connected to the battery at the high voltage side through a crimp terminal 10a. Similarly, the low voltage direct current wiring unit 7c is connected there through a connection terminal 9d from the low voltage direct current wiring unit 7b of the second circuit substrate, and connected to the battery at the low voltage side through the crimp terminal 10b.

When the semiconductor element at the high voltage side of the power module 4 becomes conductive, the high voltage direct current wiring unit 6a and the output terminal 13 get conductive and the output terminal 13 gets a high voltage. Further, when the semiconductor element at the low voltage side becomes conductive, the low voltage direct current wiring unit 7a and the output terminal 13 described later get conductive and the output terminal 13 gets a low voltage. At this time, since a current ripple occurs, a plurality of capacitors 5 between the high voltage direct current wiring unit 6a and the low voltage direct current wiring unit 7a and the capacitors 14 of the second circuit substrate 2 connected to the high voltage direct current wiring unit 6b and the low voltage direct current wiring unit 7b of the second circuit substrate 2 smooth the current, hence to restrain the current ripple from affecting the battery.

Fig. 5 is an explanatory view of the flow path forming body 3 with the first circuit substrate 1 removed from Fig. 4.

The flow path forming body 3 is sandwiched by the first circuit substrate 1 and the second circuit substrate 2 described later in Fig. 7 and fixed to the respective circuit substrates with the screws through a plurality of screw holes 22 provided on the circumference and around the rotation axis. In short, the above body forms the flow path for passing the refrigerant with the surface of the first circuit substrate 1 and the surface of the second circuit substrate 2 joined together. Further, the flow path forming body 3 has a concave portion 16a along the flow path wall since the body has to be adhered to the upper and lower circuit substrates in the axial direction not to leak the refrigerant to the outside, and by inserting an elastic material there, the leakage of the refrigerant is avoided.

The role of the respective through holes provided on the flow path forming body 3 will be described. The through holes 17 are provided at the respective positions corresponding to the power modules 4 arranged in the first circuit substrate 1. According to this structure, the power modules 4 arranged in the first circuit substrate 1 are cooled not only by the refrigerant flowing in the flow path forming body 27 but also by the refrigerant flowing in the flow path forming body 3; as the result, the power modules 4 can be cooled from the both surfaces in the axial direction. The through holes 23 serve for passing the connection terminals 9a to 9e, to electrically connect both the circuit substrates vertically sandwiching the flow path forming body 3 in the axial direction. The through holes 18 are those other than the through holes 17 and the through holes 23.

The flow path opening units 19 and 20 provided in the flow path forming body 3 will be described. The flow path opening unit 20 is an inlet for taking in the refrigerant flowing inside the above-mentioned flow path forming body 27 to the flow path inside the flow path forming body 3, through the flow path outlet unit 29 and the flow path hole 25. The refrigerant taken into the flow path forming body 3 flows through the concave portion 24 provided in the flow path forming body 3 like an arrow 21 (the details will be described later). The flow path opening unit 19 is an outlet for discharging the refrigerant having flowed through the flow path of the flow path forming body 3 from the flow path outlet unit 26 of the second circuit substrate described later.

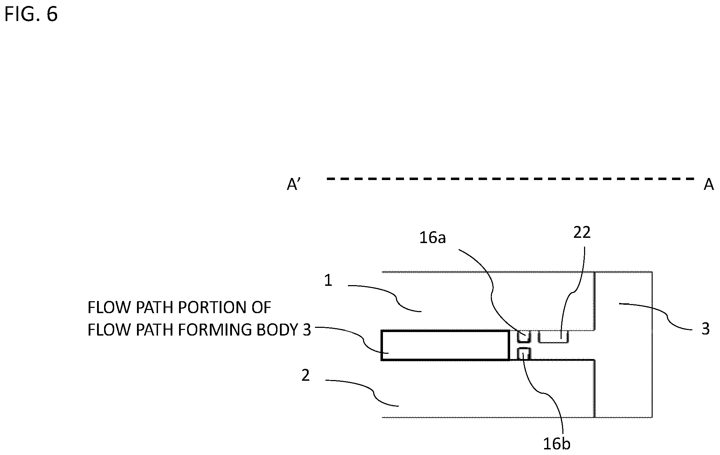

Fig. 6 is a cross-sectional view taken along the line A-A' of Fig. 5.

As mentioned above, the region inner than the fringe of the circumference of the flow path forming body 3 is vertically sandwiched by the first circuit substrate 1 and the second circuit substrate 2 in the axial direction. Here, the flow path forming body 3 is provided with a concave portion 16b in which an elastic material can be inserted, at the opposite side to the side where the first circuit substrate 1 is fitted, in order to avoid the leakage of the refrigerant. According to this, also when the second circuit substrate 2 is fitted into the flow path forming body 3, the leakage of the refrigerant can be avoided.

Fig. 7 is a view showing the first circuit substrate 1 indicated in Figs. 2 to 4 and the second circuit substrate 2 arranged on the rear surface of the flow path forming body 3. Here, the detailed description concerned to the electrical connection of the first circuit substrate 1 and the second circuit substrate 2 is as mentioned in Fig. 4 and therefore, the description is omitted.

The output terminal 13 and the output wiring unit 11b are fastened to the second circuit substrate 2 through a fastening hole 12, thereby making the output of the power module 4 of the first circuit substrate 1 and the output terminal 13 electrically conductive.

Further, the second circuit substrate 2 is provided with the flow path outlet unit 26, and as mentioned above, the refrigerant flowing from the flow path forming body 27 to the flow path opening unit 19 through the flow path forming body 3 is discharged outside from the flow path outlet unit 26.

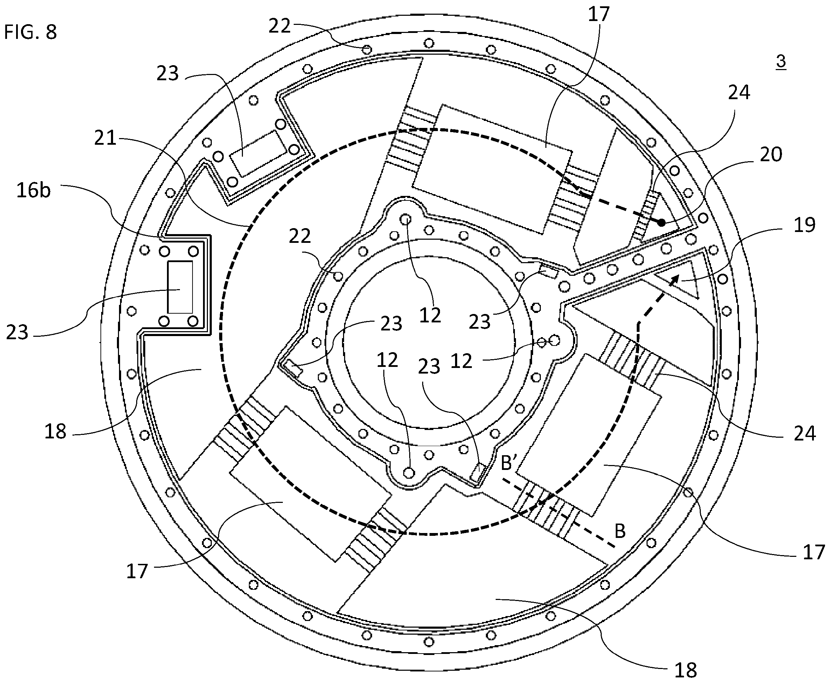

Fig. 8 is an explanatory view of the flow path forming body 3 (rear surface of Fig. 5) with the second circuit substrate 2 removed from Fig. 7. Here, the structure is the same as mentioned in Fig. 5 and the similar portion is omitted.

The fastening hole 12 is a hole for fastening the second circuit substrate 2, the output terminal 13, and the output wiring unit 11b by a screw. The screw holes 22 are holes for fitting the second circuit substrate 2 and the flow path forming body 3 by screws. Thanks to the fastness of the second circuit substrate 2 and the flow path forming body 3, not only the flow path can be formed but also the low voltage direct current wiring unit 7b of the second circuit substrate 2 can be cooled and the substrates rising in the temperature caused by the heat occurring at the conductive time can be cooled.

The concave portions 24, extending from the fringe of the circumference of the flow path forming body 3, are provided in a part of the flow path forming body 3 where the through holes 17 are formed. Further, the concave portions 24 are provided for passing the refrigerant and are arranged in the circumferential direction at two positions as for each of the through holes 17. The part of the flow path forming body 3 serves as a support pole to disturb the flow path of the flow path forming body 3 from narrowing due to the distortion of the circuit substrates when the first circuit substrate 1 and the second circuit substrate 2 are vertically fitted to the flow path forming body 3 in the axial direction. The concave portions 24 are provided in the part of the flow path forming body 3, to form the flow path where the refrigerant passes.

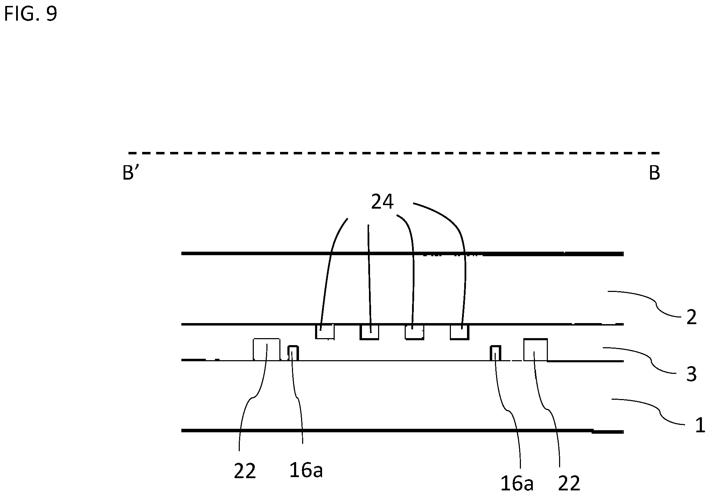

Fig. 9 is a cross-sectional view taken along the line B-B' of Fig. 8. Differently from Fig. 6, the second circuit substrate 2 is shown upward and the first circuit substrate 1 is shown downward in this drawing.

The screw holes 22, the concave portions 16a, and the concave portions 24 are arranged not to overlap with each other in the horizontal direction so as to secure the thickness to a degree capable of disturbing the distortion of the flow path forming body 3. According to this structure, both the conductivity and the safety of the flow path of the flow path forming body 3 can be secured.

The first embodiment of the invention as mentioned above has the following effects.

(1) The power conversion device includes the capacitor 5 for smoothing the direct current power, a plurality of power modules 4 for converting the direct current power into the alternating current power, the first substrate 1 on which the power modules 4 are arranged, the second substrate 2 arranged opposite to the first substrate 1, the first flow path forming body 3 which forms the flow path for passing the refrigerant with the both surfaces of the first substrate 1 and the second substrate 2 joined together, and the second flow path forming body 27 which forms the flow path together with the surface of the first substrate 1, in which the both surfaces of the power modules 4 are cooled by the refrigerant. According to this, it is possible to thin the power conversion device achieving both the cooling performance and the sealing performance.
(2) The first flow path forming body 3 of the power conversion device includes a plurality of through holes 17 for respectively cooling a plurality of power modules 4. According to this, it is possible to maintain the flow path width stably while cooling the heat generating electric parts.
(3) A plurality of power modules 4 of the power conversion device are arranged on the substrate in the circumferential direction, and the second flow path forming body 27 includes module flow path units 34 for respectively cooling the plural power modules 4 individually. According to this, it is possible to cool the heat generating electric parts by the refrigerant flowing in a series of flow paths.
(4) It includes the control circuit substrate 30 electrically connected to the first substrate 1 of the power conversion device for outputting a control signal to the plural power modules 4, and the second flow path forming body 27 has a pair of surfaces facing each other, with one surface in contact with the first substrate 1 and the other surface having the control circuit substrate 30. According to this, it is possible to cool the control circuit substrate 30 efficiently without any influence of the heat generation.
(5) The first flow path forming body 3 of the power conversion device includes a plurality of concave portions 24 for passing the refrigerant. According to this, it is possible to secure the conductive flow path while maintaining the flow path width stably.

### (Second Embodiment)

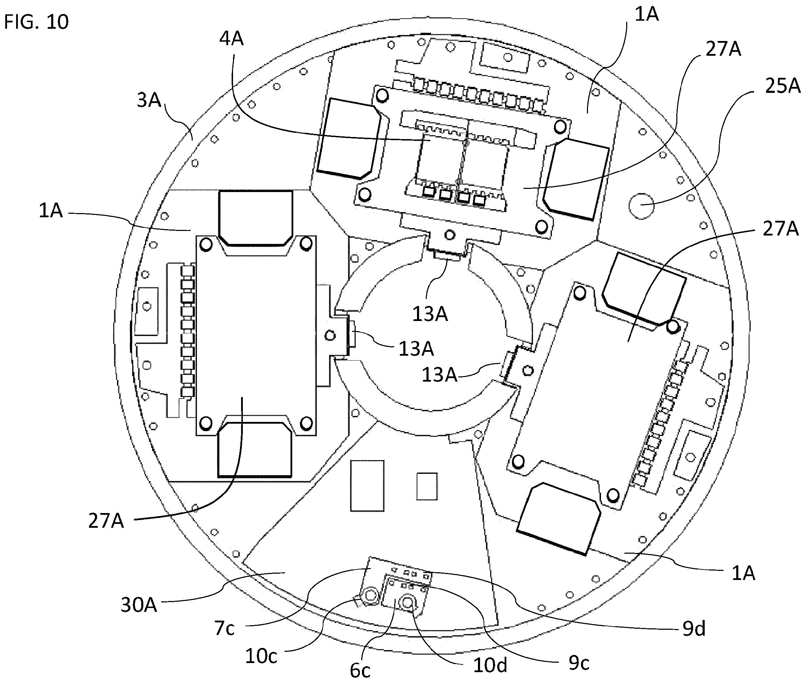

Fig. 10 is an explanatory view of a power conversion device according to a second embodiment of the invention.

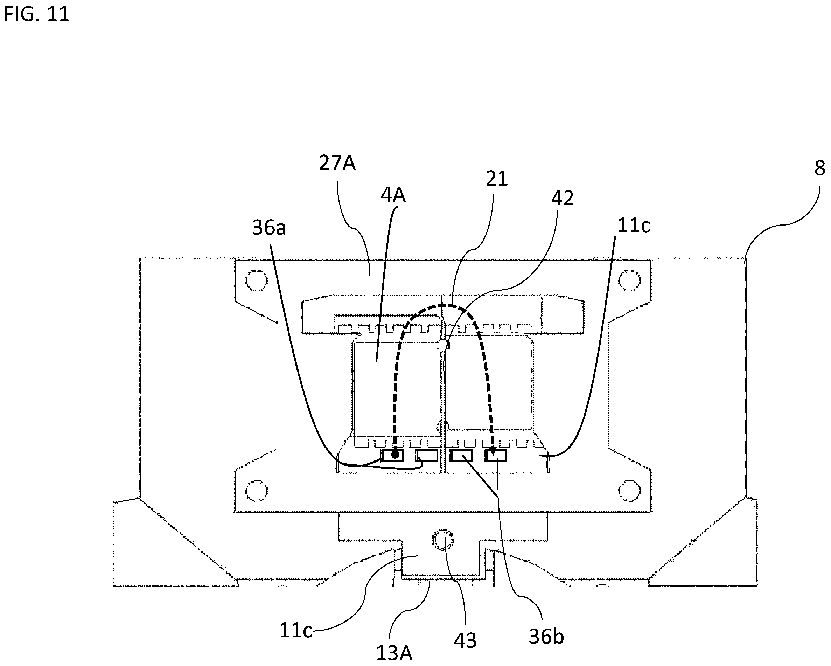

The first circuit substrate 1A is formed individually for every power module 4A, and similarly the flow path forming body 27A is also formed individually for every power module 4A not in a continuous shape. In short, each power module 4A on each first circuit substrate 1A is formed independently surrounded by the flow path forming body 27A. In Fig. 10, to make the power module 4A provided within the flow path forming body 27A easily understood, the flow path forming body 27A positioned in the top of the drawing is shown without its top. Generally, however, the top of the flow path forming body 27A is covered, like the other two flow path forming bodies 27A. The details will be described in Fig. 11.

Further, the output terminal 13A of the first circuit substrate 1A is fixed to the first circuit substrate 1A by a screw, in a manner of extending from the first circuit substrate 1A to the second circuit substrate 2 in the axial direction along the rotation axis. The flow path hole 25A is an inlet of the fluid into the power conversion device.

The control circuit substrate 30A is mounted on the flow path forming body 3A not on the first circuit substrate 1A. In other words, the control circuit substrate 30A collects the high voltage direct current wiring unit 6c, the low voltage direct current wiring unit 7c, the connection terminals 9c and 9d, and the crimp terminals 10c and 10d to be connected to the battery output, hence to improve the installation area. Here, in the second embodiment, the second circuit substrate 2 is not illustrated but the connection of the electric wiring is the same as in the first embodiment.

According to this structure, the control circuit substrate 30A can be set at a lower position than when it is set on the flow path forming body 27 in the first embodiment, at a vertical height in the axial direction of the power conversion device, hence to reduce the thickness of the whole power conversion device.

Fig. 11 is an explanatory view of the flow path forming body 27A formed in the power module 4A of Fig. 10. Any flow path forming body 27A of Fig. 10 has the similar inside structure.

As illustrated in Fig. 11, the flow path forming body 27A is formed around the power module 4A. This is because the flow path forming body 27A is formed to cover the vicinity of the resin applied to the substrate in a way of covering the power module 4A.

Further, the signal wiring unit 8 is set around the flow path forming body 27A, and an output wiring unit 11c is formed in the vicinity of a plurality of through holes 36a and 36b inside the flow path forming body 27A, extending in a radial direction toward the rotation axial center. The fastening hole 43 is provided in the output wiring unit 11c, which is fastened to the output terminal 13A below by a screw and electrically connected there.

The refrigerant is running inside the flow path forming body 27A, the refrigerant passing through the flow path forming body 3A described later flows from the through hole 36a into the flow path forming body 27A, and flows within the flow path partitioned by a shielding plate 42 like an arrow 21, and comes into the flow path forming body 3A again from the through hole 36b (the details will be described later). In short, the first circuit substrate 1A has a plurality of through holes for cooling the power module 4A.

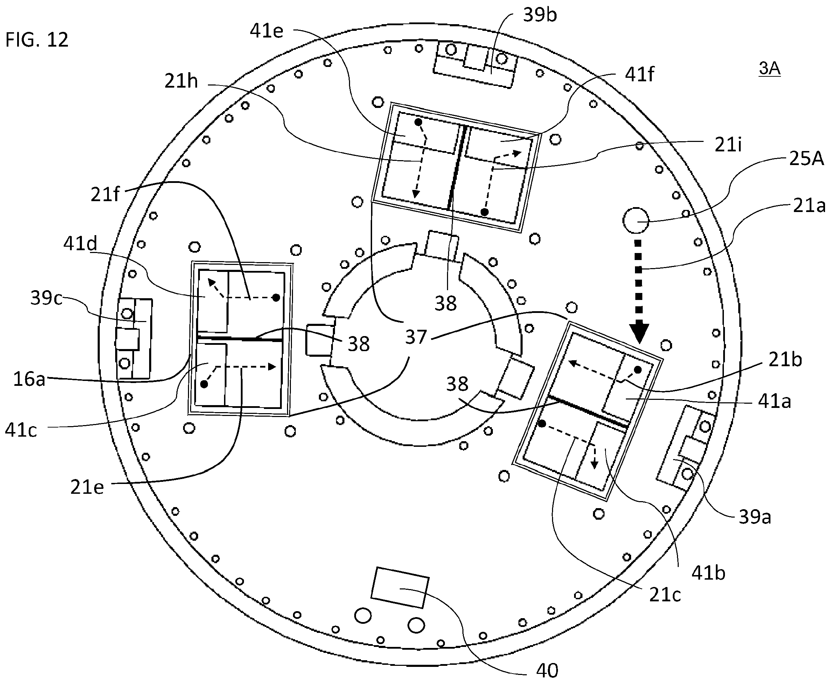

Fig. 12 is an explanatory view of the flow path forming body 3A with the first circuit substrate 1A removed from Fig. 10.

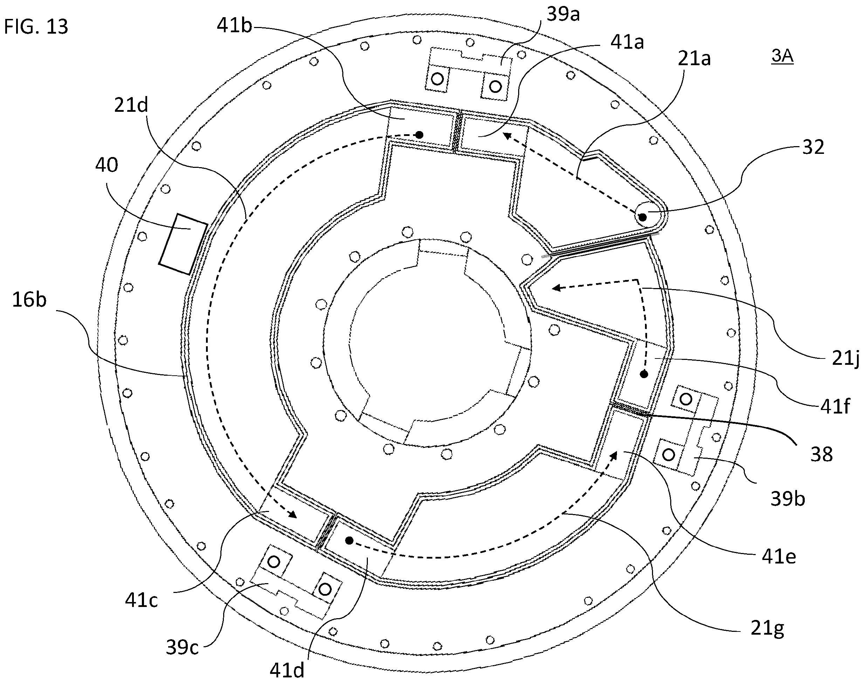

The flow path forming body 3A can be increased in the thickness toward the top direction of the paper since the flow path forming body 27 having been described in the first embodiment is not provided. Therefore, it is possible to widen the width of the flow path of Fig. 13 described later and narrow the width of the flow path in the vicinity of the through hole 37 of the flow path where the power modules 4A overlap with each other.

According to this, the flow rate can be adjusted by the flow path forming bodies 3A, and since the flow path can be narrowed to a specified position, the circuit substrates can be cooled only at the wiring portion having the heat, the flow path can be narrowed to increase the flow amount, the wiring can be efficiently cooled to make easy the substrate temperature, and it is not necessary to add the flow path, hence to contribute to realize a thinner power conversion device. Further, by an increase in the thickness of the flow path forming body 3A, the screw holes can be provided in the flow path forming body 3A deeper than in the first embodiment.

A plurality of through holes included in the flow path forming body 3A will be described. A plurality of through holes 37 is formed to cool the power modules 4A of Figs. 10 and 11 vertically from the both surfaces in the axial direction. Further, each shielding plate 38 provided to partition each space between the through holes 37 controls the flow of the refrigerant to form the intended flow path. The flow of the refrigerant (arrows of 21a to 21c, 21e, 21f, 21h, and 21i) will be described in the description of Fig. 13.

Through holes 39a to 39c pass the connection terminals for connecting the first circuit substrate 1A and the second circuit substrate 2, and a through hole 40 passes the connection terminal for connection to the battery.

The concave portion 16a has an elastic material inserted there, not to leak the refrigerant to the outside when the first circuit substrate 1A is fixed to the flow path forming body 3A.

Fig. 13 is an explanatory view of the rear surface of the flow path forming body 3A in Fig. 12. The second circuit substrate 2 fitted fixedly to the surface of the flow path forming body 3A in the axial direction is not illustrated here.

A flow of the refrigerant flowing inside the flow path forming body 3A and the flow path forming body 27A will be described using Figs. 11 to 13.

At first, the refrigerant coming from the flow path hole 25A shown in Figs. 11 and 12 flows from the flow path inlet unit 32 of Fig. 13 like the arrow 21a. Continuously, the refrigerant comes into the through hole 41a and flows like the arrow 21b of the through hole 37 in Fig. 12. At this time, the refrigerant directly cools the surface of the flow path forming body 3A in the power module 4A.

Then, the refrigerant passes through the through hole 36a of Fig. 11 provided in the first circuit substrate 1A, flows into the surface opposite to the first circuit substrate 1A, and flows on the surface of the power module 4A like the arrow 21 according to the flow path formed by the flow path forming body 27A and the shielding plate 42. According to this structure, the power module 4A can be cooled also from the surface opposite to the flow path forming body 3A side, and therefore, the power module 4A can be cooled from the both surfaces.

The refrigerant passes through the through hole 36b of Fig. 11 provided in the first circuit substrate 1A, flows again into the through hole 37 of Fig. 12, flows like the arrow 21c, and flows into the rear surface of the flow path forming body 3A from the through hole 41b like the arrow 21d.

Similarly, after flowing into the through hole 41c, the refrigerant flows like the arrow 21e in the through hole 37 of Fig. 12, and flows into the surface of the power module 4A and the flow path forming body 27A through the through hole 36a of Fig. 11. Then, it flows from the through hole 36b like the arrow 21f of Fig. 12 and flows from the through hole 41d like the arrow 21g.

As for the cooling of the other power module 4A, the refrigerant flows like the arrow 21g, to the through hole 41e, the arrow 21h, the through hole 36a, the arrow 21 (Fig. 11), the through hole 36b, the arrow 21i, the through hole 41f, and the arrow 21j.

After proceeding like the arrow 21j, the refrigerant is discharged from the flow path outlet unit 26 provided in the second circuit substrate 2 not illustrated.

The above-mentioned second embodiment of the invention has the following effects.

(6) The surface of the first substrate 1A of the power conversion device includes a plurality of the through holes 36a and 36b for cooling the power module 4A. According to this, it contributes to realize a thinner power conversion device while cooling the power module 4A.
(7) A plurality of the power modules 4A of the power conversion device are respectively provided on the circumferential direction on the substrate, and the second flow path forming bodies 27A are individually provided in the respective power modules 4A. According to this, it is possible to contribute to realize a thinner power conversion device.

### (Third Embodiment)

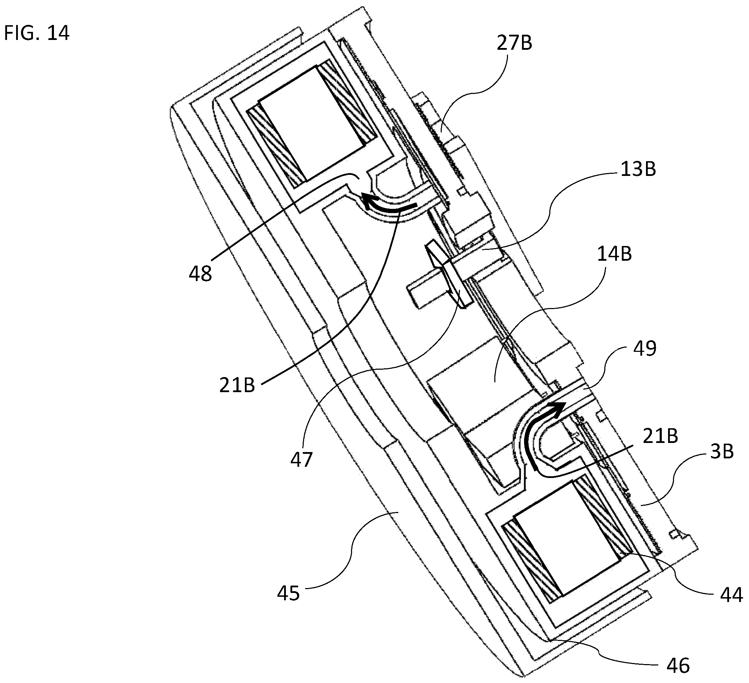

Fig. 14 is an explanatory view of a motor including the power conversion device, according to a third embodiment of the invention.

Fig. 14 shows the structure of a motor, taking by way of example of an outer rotor motor. The motor includes a rotor 45 and a stator case 46, and in the stator case 46, the flow path forming body 3B and the flow path forming body 27B are provided on the surface opposite to the side of the rotor 45.

The power conversion device is on the surface in contact with the flow path forming body 27B and the stator (not illustrated), and the output terminal 13B is connected to the distal end of the output wiring unit drawn therefrom. The output terminal 13B forms a three-phase alternating current circuit with the stator coil 44 as a load, by connecting the wiring drawn from the distal end of the stator coil 44 to the stator case 46 of the motor from the inside. By passing the three-phase alternating current to the stator coil 44, a rotation magnetic field is generated and the rotor 45 outside the stator is rotated according to the rotating magnetic field.

The capacitor 14B is arranged to be embedded in the stator case 46 in the radial direction of the axis of the stator, and in the radial direction, a space between the stator and the axis is effectively used. From the same advantage, an output current sensor 47, a stator flow path inlet 48, and a stator flow path outlet unit 49 are radially provided at the inner side from the stator coil 44.

The flow path output of the power conversion device (not illustrated) is connected to the flow path inlet unit 48 of the stator, the refrigerant flows like the arrow 21B and is discharged from the flow path outlet unit 49 of the flow path forming body 3B. According to this, by making the refrigerant flowing in the motor and the power conversion device identical, it is possible to cool the heat generating devices at once.

Here, the power conversion device may be positioned between the stator and the rotor, after gathering, for example, the flow path inlet and the flow path outlet of the refrigerant, the connection position of the output wiring unit and the crimp terminal, and the connection position of the connection terminal of the wiring of the control signal at the same surface of the substrate.

### (Fourth Embodiment)

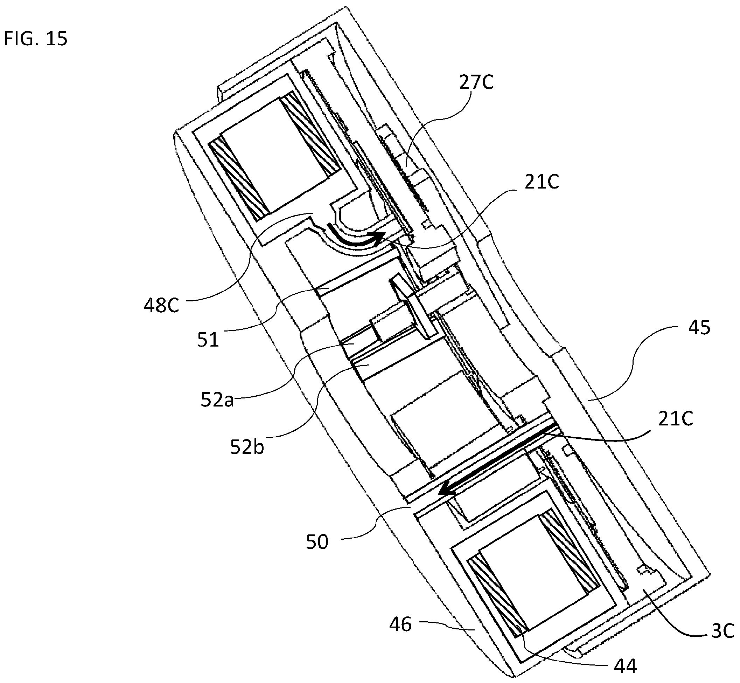

Fig. 15 is an explanatory view of a power conversion device according to a fourth embodiment of the invention.

Fig. 15 is different from Fig. 14 of the third embodiment in that the rotor 45 is provided on the surface at the side of the flow path forming bodies 3C and 27C arranged in the stator. The flow path inlet unit 48C of the stator is provided as the flow path outlet of the refrigerant having cooled the stator coil 44, which becomes the flow path continuous to the flow path inlet unit (not illustrated) of the flow path forming body 3C. According to this, the refrigerant flows like the arrow 21C, runs into the power conversion device, further flows from the flow path outlet unit (not illustrated) of the flow path forming body 3C to the flow path outlet unit 50 like the arrow 21C, and is discharged.

Further, the direct current power input wirings 52a and 52b provided inside the stator coil is connected to the input terminal on the second circuit substrate (not illustrated) provided between the flow path forming body 3C and the stator case 46 and electrically connected to the wiring of the second circuit substrate. In this case, the connection terminal working as the electrical connection of the circuit substrates is not necessary and instead, by connecting the signal input wiring 51 to the control circuit, the power and the control signal can be input externally.

### List of Reference Signs

1, 1A: First Circuit Substrate
2: Second Circuit Substrate
3, 3A to 3C, 27, 27A: Flow Path Forming Body
4: Power Module
5, 14: Capacitor
12, 43: Fastening Hole
15: One Leg Inverter
16a, 16b, 24: Concave Portion
17, 18, 23, 34, 36, 37, 40, 41a, 41b: Through Hole
19, 20: Flow Path Opening Unit
20, 32, 48: Flow Path Inlet Unit
21, 21a to 21k, 21B, 21C: Arrow indicating flow of refrigerant (fluid)
22, 31, 33: Screw Holes
25, 25A: Flow Path Hole
26, 29, 49, 50: Flow Path Outlet Unit
30, 30A: Control Circuit Substrate
38, 42: Shielding Plate
44: Stator Coil
45: Rotor
46: Stator Case

## Claims

1. A power conversion device comprising:
a capacitor (5, 14) for smoothing a direct current power;
a plurality of power modules (4) for converting the direct current power into an alternating current power;
a first substrate (1) on which the power modules are arranged;
a second substrate (2) arranged opposite to the first substrate (1);
a first flow path forming body (3) that forms a flow path for passing a refrigerant with a first surface of the first substrate and a second surface of the second substrate joined together; and
a second flow path forming body (27) that forms the flow path together with the surface of the first substrate (1),
wherein the first flow path forming body (3) includes a plurality of through holes for cooling the respective power modules (4),
wherein the power modules (4) are respectively arranged on the first substrate (1) in a circumferential direction; and
the second flow path forming body (27) includes a module flow path unit for cooling each of the power modules (4) individually.

2. The device according to claim 1, comprising
a control circuit substrate (30) electrically connected to the first substrate (1) for outputting a control signal of the power modules (4), in which
the second flow path forming body (27) has a pair of a first surface and a second surface, wherein the first surface is in contact with the first substrate (1) and on the second surface the control circuit substrate (30) is mounted.

3. The device according to claim 1, in which
the first flow path forming body (3) includes a plurality of concave portions for passing the refrigerant.

4. The device according to claim 1, in which
the first substrate (1) includes a plurality of through holes for cooling the power modules (4).

5. The device according to claim 4, in which
the power modules (4) are respectively arranged on the first substrate (1) in a circumferential direction, and
the second flow path forming body (27) is provided in each of the power modules (4) individually.

## Patentansprüche

1. Leistungsumsetzungsvorrichtung, die Folgendes umfasst:
einen Kondensator (5, 14) zum Glätten von Gleichstromleistung;
mehrere Leistungsmodule (4) zum Umsetzen der Gleichstromleistung in Wechselstromleistung;
ein erstes Substrat (1), auf dem die Leistungsmodule angeordnet sind;
ein zweites Substrat (2), das gegenüber dem ersten Substrat (1) angeordnet ist;
einen ersten einen Strömungsweg bildenden Körper (3), der einen Strömungsweg für den Durchgang von Kühlmittel mit einer ersten Oberfläche des ersten Substrats und einer zweiten Oberfläche des zweiten Substrats, die miteinander verbunden sind, bildet; und
einen zweiten einen Strömungsweg bildenden Körper der den Strömungsweg zusammen mit der Oberfläche des ersten Substrats (1) bildet,
wobei der erste einen Strömungsweg bildende Körper (3) mehrere Durchgangslöcher aufweist, um die jeweiligen Leistungsmodule (4) zu kühlen,
wobei die Leistungsmodule (4) jeweils auf dem ersten Substrat (1) in einer Umfangsrichtung angeordnet sind; und
der zweite einen Strömungsweg bildende Körper (27) eine Modul-Strömungswegeinheit zum individuellen Kühlen jedes der Leistungsmodule (4).

2. Vorrichtung nach Anspruch 1, die Folgendes umfasst:
ein Steuerschaltungssubstrat (30), dass mit dem ersten Substrat (1) elektrisch verbunden ist, um ein Steuersignal der Leistungsmodule (4) auszugeben, wobei
der zweite einen Strömungsweg bildende Körper (27) ein Paar aus einer ersten Oberfläche und einer zweiten Oberfläche besitzt, wobei die erste Oberfläche mit dem ersten Substrat (1) in Kontakt ist und auf der zweiten Oberfläche das Steuerschaltungssubstrat (30) montiert ist.

3. Vorrichtung nach Anspruch 1, wobei
der erste einen Strömungsweg bildende Körper (3) mehrere konkave Abschnitte für den Durchgang des Kühlmittels aufweist.

4. Vorrichtung nach Anspruch 1, wobei
das erste Substrat (1) mehrere Durchgangslöcher aufweist, um die Leistungsmodule (4) zu kühlen.

5. Vorrichtung nach Anspruch 4, wobei
die Leistungsmodule (4) jeweils auf dem ersten Substrat (1) in einer Umfangsrichtung angeordnet sind und
der zweite einen Strömungsweg bildende Körper (27) in jedem der Leistungsmodule (4) einzeln bereitgestellt ist.

## Revendications

1. Dispositif de conversion de puissance comprenant :
un condensateur (5, 14) destiné à lisser une puissance en courant continu ;
une pluralité de modules de puissance (4) destinés à convertir la puissance en courant continu en une puissance en courant alternatif ;
un premier substrat (1) sur lequel sont agencés les modules de puissance ;
un second substrat (2) agencé à l'opposé du premier substrat (1) ;
un premier corps formant trajet d'écoulement (3) qui forme un trajet d'écoulement pour faire passer un réfrigérant avec une première surface du premier substrat et une seconde surface du second substrat jointes l'une à l'autre ; et
un second corps formant trajet d'écoulement (27) qui forme le trajet d'écoulement conjointement avec la surface du premier substrat (1),
dans lequel le premier corps formant trajet d'écoulement (3) inclut une pluralité de trous traversants destinés à refroidir les modules de puissance respectifs (4),
dans lequel les modules de puissance (4) sont agencés respectivement sur le premier substrat (1) dans une direction circonférentielle ; et
le second corps formant trajet d'écoulement (27) inclut une unité de trajet d'écoulement de module destinée à refroidir chacun des modules de puissance (4) individuellement.

2. Dispositif selon la revendication 1, comprenant
un substrat à circuit de commande (30) connecté électriquement au premier substrat (1) destiné à sortir un signal de commande des modules de puissance (4), dans lequel
le second corps formant trajet d'écoulement (27) a une paire d'une première surface et d'une seconde surface, la première surface étant en contact avec le premier substrat (1) et le circuit à circuit de commande (30) étant monté sur la seconde surface.

3. Dispositif selon la revendication 1, dans lequel
le premier corps formant trajet d'écoulement (3) inclut une pluralité de portions concaves destinées à faire passer le réfrigérant.

4. Dispositif selon la revendication 1, dans lequel
le premier substrat (1) inclut une pluralité de trous traversants destinés à refroidir les modules de puissance (4).

5. Dispositif selon la revendication 4, dans lequel
les modules de puissance (4) sont agencés respectivement sur le premier substrat (1) dans une direction circonférentielle, et
le second corps formant trajet d'écoulement (27) est prévu dans chacun des modules de puissance (4) individuellement.
